# EUROPÄISCHE PATENTSCHRIFT

(11) **EP 0 744 473 B1**
(45) Veröffentlichungstag und Bekanntmachung des Hinweises auf die Patenterteilung: **25.03.1998**
(21) Anmeldenummer: 96106600.8
(22) Anmeldetag: 26.04.1996
(51) Int. Cl.: C23C 14/08, C23C 14/00

(54) **Vakuumbeschichteter Verbundkörper und Verfahren zu seiner Herstellung**
Vacuum coated composite body and method of its production
Pièce composite, revêtue sous vide et son procédé de fabrication

(30) Priorität: 22.05.1995 DE 19518781
(43) Veröffentlichungstag der Anmeldung: 27.11.1996
(73) Patentinhaber: FRAUNHOFER-GESELLSCHAFT ZUR FÖRDERUNG DER ANGEWANDTEN FORSCHUNG E.V., 80636 München (DE)
(72) Erfinder: Goedicke, Klaus, 01307 Dresden (DE); Hötzsch, Günter, Dr., 01259 Dresden (DE); Fietzke, Fred, Dr., 01127 Dresden (DE); Zywitzki, Olaf, 09599 Freiberg (DE); Schiller, Siegfried, Prof. Dr., 01324 Dresden (DE); Reschke, Jonathan, 01307 Dresden (DE); Hempel, Wolfgang, 01326 Dresden (DE)

(56) Entgegenhaltungen:
- EP-A- 0 539 694
- EP-A- 0 605 299
- WO-A-94/25637

## Beschreibung

Die Erfindung bezieht sich auf einen Verbundkörper, dessen Träger vorzugsweise aus Metall besteht, auf dem eine oder mehrere Oberflächenschichten aufgebracht sind, von denen mindestens eine Schicht durch Vakuumbeschichtung abgeschieden ist und aus Aluminiumoxid (Al₂O₃) besteht. DerartigeVerbundkörper werden beispielsweise als Werkzeuge für die spanende Bearbeitung, Umformwerkzeuge, Maschinenteile oder Führungsbahnen verwendet.

Es sind Verbundkörper bekannt, die eine Al₂O₃-Schicht enthalten, welche durch chemische Dampfphasenabscheidung (CVD) bei Temperaturen oberhalb 1000 °C auf dem Träger aus Sinterwerkstoff abgeschieden worden sind. Derartige Schichten sind kristallin und enthalten neben der thermodynamisch stabilen α-Phase im allgemeinen weitere metastabile Phasen, insbesondere die K-Phase (DE 22 33 700; DE 22 53 745). Wegen der hohen Temperatur, der der Träger bei der Beschichtung ausgesetzt werden muß, beschränkt sich die Art der verwendbaren Träger jedoch auf Sinterwerkstoffe, Oxidkeramiken und andere Hochtemperaturwerkstoffe. Insbesondere sind alle gebräuchlichen Stähle und Nichteisenwerkstoffe ausgeschlossen, oder der Träger erfährt eine nicht akzeptable Verschlechterung seiner Gebrauchseigenschaften. Bedeutung haben deshalb nur Verbundkörper erlangt, deren Träger aus Sinterwerkstoffen bestehen und die in Schneidwerkzeugen, z.B. als Wendeschneidplatten, eingesetzt werden. Beim Einsatz in Schneidwerkzeugen unterliegen solche Verbundkörper hohen Temperaturen. Diese sind mit einer Phasenumwandlung in der Al₂O₃-Schicht, insbesondere der K-Phase verbunden. Die Schichten haben eine rauhe Oberfläche und relativ hohe Reibungskoeffizienten. Durch eine Volumenkontraktion bei der Phasenumwandlung kommt es zu einer ausgeprägten Rißbildung und einer Delamination zwischen Schicht und Träger. Daraus resultiert der Nachteil, daß einschneidende Grenzen für den Einsatz der Verbundkörper in Bezug auf die Gebrauchsdauer bestehen. Um die Delamination auf Schneidwerkzeugen in Grenzen zu halten, müssen die Schneidkanten des Trägers abgerundet werden. Daraus resultieren aber erhebliche Begrenzungen der Schneidleistung und der Oberflächengüte der spanend bearbeiteten Werkstücke.

Die Verwendung von Trägern aus Werkzeugstählen ist generell nicht möglich, da diese Stähle bei Temperaturen oberhalb 550°C ihre vorteilhaften Gebrauchseigenschaften verlieren.

Es sind weiterhin Verbundkörper bekannt, die eine bei niedrigen Temperaturen durch plasmagestützte CVD-Verfahren abgeschiedene Al₂O₃-Schicht besitzen (DE 41 10 005; DE 41 10 006). Derartige Schichten enthalten verfahrensbedingt Verunreinigungen, die aus einer unvollständigen chemischen Reaktion herrühren. Diese Schichten weisen beispielsweise einen Chlorgehalt von 0,5 bis 3,5 % auf. Die Al₂O₃-Schichten auf diesen Verbundkörpern enthalten neben kristallinem α-Al₂O₃ im allgemeinen einen hohen Anteil amorphen Aluminiumoxids. Daraus ergibt sich der Nachteil, daß sowohl die Verunreinigungen im Al₂O₃ als auch die amorphe Phase eine unzureichende chemische, mechanische und thermische Beständigkeit der Schicht auf dem Verbundkörper bewirken. Es sind auch feinkörnige, nur aus α-Al₂O₃ bestehende Schichten auf Verbundkörpern bekannt. Dabei wird eine aus der Halbwertsbreite der Interferenzlinien bei der Röntgenfeinstrukturanalyse (XRD) der Schichten abgeleitete Bemessungsregel für die Feinkörnigkeit angegeben. Als Herstellungsverfahren wird ein Plasma-CVD-Verfahren mit den obengenannten Nachteilen beschrieben (DE 41 10 005; DE 41 10 006). Es kann angenommen werden, daß die Linienbreite im XRD vorwiegend auf Gitterverzerrungen infolge des Fremdstoffgehaltes der Schichten und nicht, wie angegeben, nur auf die Feinkörnigkeit des Gefüges der Al₂O₃-Schichten zurückgeführt werden muß. Generell erfordern alle CVD-Verfahren die Verwendung toxischer Substanzen und sind deshalb umweltbelastend.

Es ist weiterhin bekannt, Al₂O₃-Schichten auf Trägerkörpern durch Hochfrequenz-Dioden- oder -Magnetron-Zerstäubung abzuscheiden (Thornton und Chin, Ceramic Bulletin, 56 [1977]504).Es wird beschrieben, daß kristalline α-Al₂O₃-Schichten mit diesem Verfahren ebenfalls nur erzeugt werden können, wenn der Verbundkörper bei der Beschichtung einer Temperatur von mindestens 1000 °C ausgesetzt wird. Anderenfalls ist eine nachträgliche Wärmebehandlung bei 1000 ...1250 °C erforderlich. Die damit verbundenen Nachteile entsprechen denen der Schichten, die durch CVD-Verfahren abgeschieden worden sind.

Es wurde auch beschrieben, daß bei Al₂O₃-Schichten, die durch Zerstäubung hergestellt wurden, eine relativ hohe Härte erreicht werden kann, aber diese Schichten weisen eine röntgenamorphe Struktur auf, was nachteilig für die Stabilität beim Einsatz ist (Scherer, Latz und Patz; Proc. 7th Int. Conf. IPAT, Geneva, 1989, p. 181).

Somit ist festzustellen, daß die bekannten vakuumbeschichteten Verbundkörper stets mit Mängeln behaftet sind. Weiterhin sind die Verbundkörper, deren Träger durch CVD- oder HF-Zerstäubungsverfahren mit Al₂O₃ beschichtet sind, teuer in der Herstellung, da alle genannten Verfahren nur eine niedrige Abscheiderate von weniger als 1 nm/s ermöglichen. Werden Verbundkörper zur Erhöhung der Abscheiderate mit einer Al₂O₃-Schicht durch reaktives Vakuumbedampfen der Träger hergestellt, so sind die Al₂O₃-Schichten porös und nicht ausreichend hart, selbst wenn der Träger bei der Beschichtung auf eine Temperatur von 1000 °C erhitzt wird (Bunshah, Schramm; Thin Solid Films 40 [1977]211).

Der Erfindung liegt die Aufgabe zugrunde, die Mängel am Stand der Technik zu beseitigen. Es soll ein Verbundkörper mit einer thermisch, mechanisch und chemisch stabilen Al₂O₃-Schicht geschaffen werden, die eine glatte, rißfreie Oberfläche aufweist. Das Verfahren zu seiner Herstellung soll umweltfreundlich sein, eine hohe Prozeßstabilität aufweisen und kostengünstig sein. Insbesondere soll auch ein Verbundkörper, dessen Träger aus Stahl besteht, geschaffen werden.

Erfindungsgemäß wird die Aufgabe, ein Verbundkörper, mit den Merkmalen des Anspruches 1 gelöst.Das Verfahren zu seiner Herstellung wird nach den Merkmalen des Anspruches 6 gelöst. Weitere vorteilhafte Ausgestaltungen des Verbundkörpers und des Hertellungsverfahrens sind in den Ansprüchen 2 bis 5 bzw. 7 bis 9 beschrieben.

Für die Fachwelt überraschend wurde gefunden, einen Verbundkörper mit einer äußersten Schicht aus vollständig kristallinem α-Al₂O₃ herzustellen, auch wenn dessen Träger während der Abscheidung der Schicht eine Temperatur von maximal 700 °C nicht überschreitet. Es wurde dabei weiterhin festgestellt, daß bereits eine Temperatur von 550 °C ausreicht, um besagte Schicht abzuscheiden. Die Al₂O₃-Schicht enthält typischerweise einen Anteil von maximal 1 at% Argon. Andere Verunreinigungen lassen sich mit gebräuchlichen Analyseverfahren wie Elektronenstrahl-Mikroanalyse (ESMA) nicht nachweisen. Die Kristallitgröße beträgt typischerweise 0,5...2 µm. Die Eigenschaften des Verbundkörpers sind weitgehend identisch, wenn besagte Al₂O₃-Schicht nicht ausschließlich in der α-Phase vorliegt, sondern teilweise aus texturiertem γ-Al₂O₃ besteht. Für diese Schichten wird eine geringere Kristallitgröße beobachtet, vorzugsweise 0,05...0,1 µm. Die Ausbildung der beschriebenen kristallinen Phasen, insbesondere die Ausbildung reiner α-Al₂O₃-Schichten, scheint im Widerspruch zu den bisher allgemein anerkannten thermodynamisch begründeten Bildungsbedingungen für diese Phase zu stehen. Danach wäre eine Aktivierungsenergie für die Bildung von α-Al₂O₃ erforderlich, die nur oberhalb einer Temperatur von 1000 °C aufgebracht werden kann. Offensichtlich bewirkt das erfindungsgemäße Verfahren durch eine nicht im einzelnen verstandene zusätzliche Aktivierung der Komponenten Aluminium und Sauerstoff im Plasma einen nennenswerten zusätzlichen Beitrag zur notwendigen Aktivierungsenergie.

Außer den materialspezifischen Eigenschaften von α-Al₂O₃ sind die angegebene Bemessung der Druckeigenspannungen und die genannten Kristallitgrößen für die hohe Härte der äußeren Schicht des Verbundkörpers verantwortlich. Die geeignete Bemessung der Druckeigenspannung gewährleistet, daß kein vorzeitiges Versagen der Schicht durch mechanische Rißbildung bei abrasiver Belastung des Verbundkörpers auftritt. Andererseits können die Druckeigenspannungen so klein gehalten werden, daß die Haftung der Al₂O₃-Schicht auf dem Träger problemlos erreicht werden kann. Das gilt insbesondere, wenn der Träger mit einer oder mehreren Oberflächenschichten, die als Zwischenschichten vor dem Abscheiden der Al₂O₃-Schicht aufgebracht worden sind, versehen ist. Als Zwischenschichten eignen sich vorteilhafterweise bekannte Hartstoffschichten wie TiN, (Ti,Al)N oder TiC.

Es kann auch zweckmäßig sein, den Träger zunächst nit einer oder mehreren Schichten aus Metallen der Gruppe Ti, Zr, Cr, Al, Nb, Hf, W und/oder Verbindungen dieser Metalle in Form von Oxiden, Nitriden, Oxynitriden, Karbiden oder Carbonitriden zu versehen, der dann als Träger für die Al₂O₃-Schicht dient.

Ist der Verbundkörper als Werkzeug für die spanende Bearbeitung als Bohrer, Fräser, Reibahle oder Räumnadel ausgebildet, so besteht der Träger aus HSS-Stahl. In diesem Anwendungsfall ist die Al₂O₃-Schicht als äußere Schicht 1 bis 12 µm dick und an den Schneidkanten vorzugsweise 5 µm dick.

Ist der Verbundkörper ein Umformwerkzeug, so besteht sein Träger aus Werkzeugstahl und trägt eine äußere Al₂O₃-Schicht von 1 bis 20 µm Dicke, die jedoch vorzugsweise 5 µm dick ist. In dieser Ausführungsform weist der Verbundkörper einen geringen Reibungskoeffizietnen und hohe mechanische Beständigkeit auf.

Werden an den Verbundkörper vor allem hohe Anforderungen an Härte, mechanischen Verschleißwiderstand, Transparenz und/oder geringere Reibungskoeffizienten der Oberfläche gestellt, ist es auch je nach Einsatzgebiet möglich, den Träger aus Aluminium oder einer Aluminiumlegierung herzustellen.

Weitere Einsatzgebiete für die erfindungsgemäßen Verbundkörper sind Bauteile für Führungsbahnen oder Gleit- und Lagerelemente, die einem komplexen mechanisch-abrasiven und chemisch-korrosiven Angriff ausgesetzt sind. Dabei wirkt sich ebenfalls der niedrige Reibungskoeffizient sehr vorteilhaft aus

Die erfindungsgemäßen Verbundkörper können auch dem Angriff heißer und/oder chemisch aggressiver Medien widerstehen und finden deshalb in der Energieerzeugungs- und Antriebstechnik Verwendung.

Das erfindungsgemäße Verfahren zur Herstellung des Verbundkörpers nutzt in vorteilhafter Weise bekannte Grundverfahren und Einrichtungen zur Abscheidung elektrisch isolierender Verbindungsschichten durch Magnetron-Zerstäubung ohne Anwendung einer HF-Entladung. Das pulsförmig erregte Plasma sichert die Stabilität des Zerstäubungsprozesses trotz des hohen Isolationsvermögens von Al₂O₃-Schichten und verhindert Prozeßstörungen durch elektrische Überschläge. Das vorgeschlagene Prinzip ermöglicht die Anwendung einer so hohen Abscheiderate und Plasmadichte in der Puls-Ein-Zeit, daß offenbar die vermutete Plasmaaktivierung bei der Schichtbildung des kristallinen α-Al₂O₃ erreicht wird. Unverzichtbares Verfahrensmerkmal ist die ebenfalls pulsförmige wechselweise Beaufschlagung der sich bildenden Schicht mit negativen und positiven Ladungsträgern der angegebenen Mindeststromdichte.

Eine vorteilhafte Ausgestaltung des Verfahrens nutzt Einrichtungen mit unipolar gepulstem Plasma unter Verwendung eines im reaktiven Gas zerstäubten Al-Targets.

Eine weitere, besonders vorteilhafte Ausgestaltung nutzt die Doppelanordnung zweier Al-Targets, die durch eine bipolare (Wechsel-)Spannung gespeist werden und bei der die Al-Targets im Wechsel Katode und Anode beim Magnetron-Zerstäuben bilden.

Die Einstellung des Sauerstoffgehaltes im Plasma wird durch geometrische Bedingungen der Zerstäubungsapparatur beeinflußt und muß deshalb experimentell ermittelt werden. Der notwendige Sauerstoffgehalt ist, offenbar wegen der erhöhten Temperatur des zu beschichtenden Trägers, wesentlich höher, als er nach der allgemeinen Praxis zur Abscheidung stöchiometrischer Aluminiumoxid-Schichten eingestellt werden muß. Damit ist eine stärkere Bedeckung der Al-Targets mit Al₂O₃ verbunden. Im dynamischen Gleichgewicht zwischen der Bildung von Al₂O₃ auf dem Target und seiner Wiederzerstäubung wird eine weitere Ursache dafür gesehen, daß sich in der Dampfphase Molekül-Bruchstücke befinden, die eine Voraussetzung für die Bildung kristalliner Phasen bei den verfahrensspezifisch niedrigen Temperaturen des Trägers sind.

Beide Verfahrensvarianten werden vorteilhaft unter Einwirkung einer Wechselspannung am Träger, einer sogenannten Puls-Bias-Spannung, ausgeführt. Die Einstellung der erfindungsgemäßen Werte für Druckeigenspannung und Härte der Al₂O₃-Schicht auf dem Träger erfolgt durch Anpassung dieser Spannung. Die Begrenzung der Temperatur auf 700°C, vorzugsweise jedoch auf 550°C bei der Herstellung des Verbundkörpers hat weitreichende Auswirkungen auf die Eigenschaften des Verbundkörpers. Besteht der Träger z.B. aus einem HSS-Stahl, so wird durch die Begrenzung der Temperatur auf maximal 550°C die Vielzahl der vorteilhaften Werkstoff- und Bearbeitungseigenschaften beibehalten. Die direkte Abscheidung der thermodynamisch stabilen α-Al₂O₃-Phase ohne nachträgliche Phasenumwandlung ist der Grund für die völlige Rißfreiheit des Verbundkörpers. Auch Al₂O₃-Schichten mit einem großen Anteil an γ-Al₂O₃ zeigen keinerlei Rißbildung, wenn sie nachträglich oder bei ihrem Einsatz erwärmt werden.

An einem Ausführungsbeispiel sollen der erfindungsgemäße Verbundkörper und das Verfahren zu seiner Herstellung näher erläutert werden. In der zugehörigen Zeichnung zeigen:
- Fig. 1:: eine beispielhafte Ausführungsform des Verbundkörpers als Sägeblatt ohne Beschichtung,
- Fig. 2:: einen Schnitt durch einen beschichteten Verbundkörper,
- Fig. 3:: ein Ergebnis der Röntgenfeinstrukturanalyse der äußeren Oberflächenschicht und des Trägers aus einem Eisenwerkstoff

Ein Träger 1 aus gehärtetem Werkzeugstahl in Form eines Kreissägeblattes ist in einem bekannten Vakuumbeschichtungsprozeß mit einer Schicht 2 aus Ti(C,N)ₓ versehen. Eine Bohrung 3 dient zum Einspannen des Trägers 1 während der weiteren Prozeßschritte zur Herstellung des Verbundkörpers sowie zum Einspannen während des Gebrauchs als Werkzeug. Im Bereich der Sägezähne 4 beträgt die Schichtdicke der Schicht 2 etwa 6±1 um sowohl auf den Flanken 5 als auch auf deren Flächen 6. In Richtung zur Bohrung 3 fällt die Schichtdicke monoton ab. Der Träger 1 mit der Schicht 2 bilden gemeinsam den Grundkörper, auf dem eine im Vakuum abgeschiedene Al₂O₃-Schicht 7 aufgebracht ist. Die Al₂O₃-Schicht 7 hat im Bereich der Flanken 5 und der Flächen 6 eine Dicke von 4±1 µm. Ihre Schichtdicke fällt ebenfalls in Richtung zur Bohrung 3 monoton ab. Merkmalbestimmend für den Verbundkörper ist, daß er während der Abscheidung der Al₂O₃-Schicht 7 einer Maximaltemperatur von 500°C ausgesetzt worden ist und daß die Al₂O₃-Schicht 7 vollständig kristallin ist.

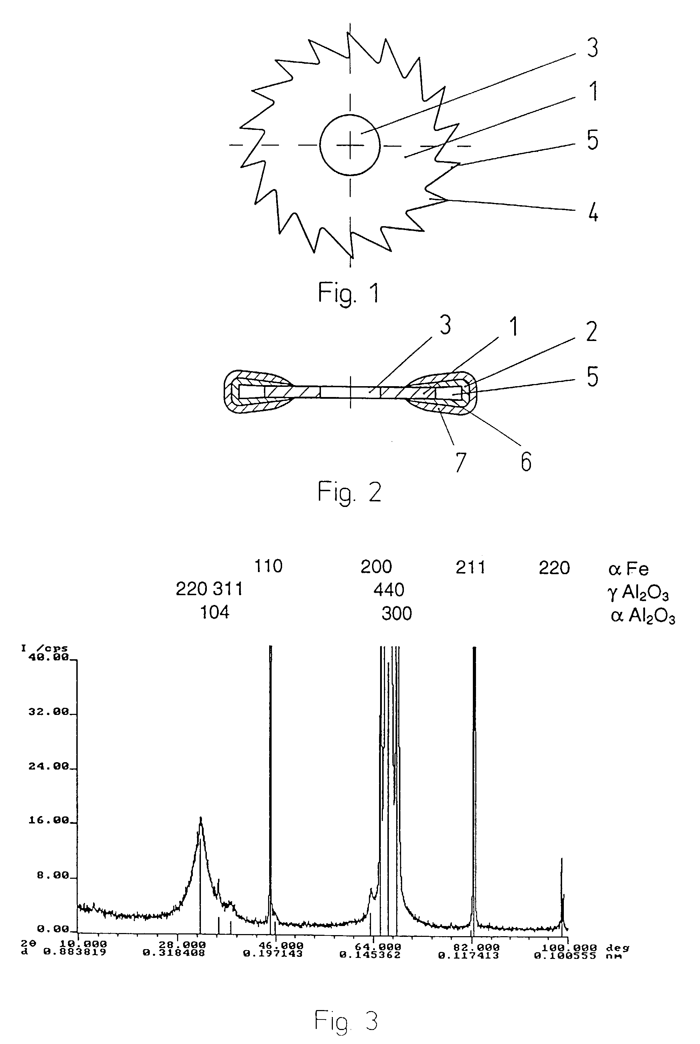

Fig. 3 zeigt das Ergebnis der Röntgenfeinstrukturanalyse der Al₂O₃-Schicht 7 und des Trägers 1. Es wurde mit einem Röntgendiffraktometer und Cu K_{α}-Strahlung gewonnen. Als Abszisse ist der Netzebenenabstand d bzw. der Glanzwinkel 2 θ dargestellt. Als Ordinate ist die Intensität der Interferenzen aufgetragen. Es lassen sich die Interferenzlinien der α-Al₂O₃-Phase und der γ-Al₂O₃-Phase erkennen. Weitere metastabile Phasen sind nicht vorhanden.

Weitere Merkmale der Al₂O₃-Schicht 7 sind eine Mindest-Druckeigenspannung von 1 GPa (im Beispiel wurde der Bereich der Druckeigenspannung zu 3,0 ± 0,5 GPa bestimmt) sowie eine hohe Härte von 21 GPa. Diese Größe wird durch Mikrohärteprüfung HV 0.01 bestimmt. Eine Elektronenstrahl-Mikroanalyse zeigt einen Argon-Gehalt von (0,3 ± 0,1) at% in der Al₂O₃₋Schicht 7 sowie das Fehlen weiterer Verunreinigungen mit einer Konzentration oberhalb der Nachweisgrenze dieses Verfahrens. Der Verbundkörper zeigt eine hervorragende Haftfestigkeit der Oberflächenschichten, eine verglichen mit CVD-Schichten sehr geringe mittlere Rauheit und einen Reibungskoeffizient gegen Stahl von weniger als 0,15. Auf Grund seiner Eigenschaften wird der Verbundkörper als hochleistungsfähiges Schneidwerkzeug bei der spanenden Bearbeitung von Stählen mit unterbrochenem und kontinuierlichem Schnitt verwendet. Im Vergleich zu herkömmlichen Schneidwerkzeugen zeichnet er sich durch eine höhere Belastbarkeit und eine deutlich erhöhte Gebrauchsdauer (Standweg) aus.

Das Verfahren zur Herstellung des Verbundkörpers wird wie folgt ausgeübt: Der Träger, der aus Werkzeugstahl und einer darauf aufgebrachten Ti(C,N)ₓ-Schicht besteht, wird nach der Reinigung in eine Vakuumbeschichtungsanlage eingebracht und in bekannter Weise in einer Niederdruck-Glimmentladung durch einen Ätzprozeß vorbehandelt. Durch einen leistungsfähigen Strahlungsheizer im Inneren der Vakuumbeschichtungsanlage wird eine Temperatur des Trägers von 500 °C eingestellt und konstant gehalten. Für die Abscheidung der Al₂O₃-Schicht wird der Träger unter Nutzung der Bohrung auf rotierenden, stabförmigen Aufnahmen gehaltert, wobei der Abstand zwischen je zwei Trägern 30 mm beträgt. Durch planetenartige Bewegung wird erreicht, daß alle zu beschichtenden Flächen des Trägers dem schichtbildenden Teilchenstrom ausgesetzt werden. Zur Erzeugung des Teilchenstromes dient eine Anordnung von zwei Magnetron-Zerstäubungsquellen mit Aluminium-Targets, die mit einem leistungsfähigen speziellen Sinusgenerator derart verbunden sind, daß mit einer Pulswechselfrequenz von 50 kHz beide Zerstäubungsquellen im Wechsel als Anode und Katode der Zerstäubungsanordnung wirken. In der Vakuumbeschichtungsanlage wird ein Druck von 0,1 Pa eingestellt. Das Gas besteht aus Argon und einem Anteil von etwa 25 at% Sauerstoff. Zur Einstellung eines stabilen Betriebes der Zerstäubungsanordnung und der genauen Justierung des Sauerstoff-Anteils werden die Magnetron-Zerstäubungsquellen zunächst in reinem Argon-Gas gezündet und dann der Sauerstoff-Gehalt so weit erhöht, bis sich ein vorgegebener Punkt in der Strom-Spannungs-Kennlinie und vorgegebene, mittels optischer Spektroskopie kontrollierte Linienintensitäten ergeben. Bei einer in die Magnetron-Zerstäubungsquellen eingespeisten elektrischen Leistung von 30 kW wird eine Abscheiderate für Al₂O₃ erreicht, die einem Wert von 8 nm/s auf einem fest angeordneten Träger entspricht. Die sich bildende Al₂O₃-Schicht ist dem intensiven Puls-Plasma in der Umgebung der Magnetron-Zerstäubungsquellen ausgesetzt. Der kürzeste Abstand zwischen den bewegten Trägern und den Targets der Magnetron-Zerstäubungsquellen beträgt 30 mm. Die Träger sind weiterhin an ihrer Bohrung elektrisch leitend mit den Aufnahmen verbunden. Die Aufnahmen werden während des Abscheidens der Al₂O₃-Schicht mit einer Sinus-Wechselspannungsquelle mit einer Frequenz von 10 kHz derart zusammengeschaltet, daß sich eine effektive Wechselspannung von ± 40 V gegenüber dem Plasma und ein pulsierender Strom wechselnder Polarität einstellt, der einem Ladungsträgerstrom mit einer mittleren Stromdichte von 1,2 mA/cm² entspricht, bezogen auf die aufwachsende Al₂O₃-Schicht. Der Beschichtungsprozeß zur Abscheidung der Al₂O₃-Schicht zeichnet sich trotz des hohen elektrischen Isolationsvermögens der Al₂O₃-Schichten, die sich auf allen inneren Wandungen der Vakuumbeschichtungsanlage abscheiden, durch eine hohe Langzeitstabilität aus. Nach Erreichen der vorgegebenen Dicke der Al₂O₃-Schicht werden die Magnetron-Zerstäubungsquellen ausgeschaltet. Nach Abkühlung der beschichteten Träger werden diese der Vakuumbeschichtungsanlage entnommen. Die beschichteten Verbundkörper stehen ohne weitere thermische Nachbehandlungsprozesse für ihren Einsatz bereit.

## Patentansprüche

1. Vakuumbeschichteter Verbundkörper, bestehend aus einem Träger aus Metall oder einer Metallegierung, auf dem mindestens eine Schicht, als die äußerste Schicht, aus Al₂O₃ in einem Vakuumbeschichtungsprozeß aufgebracht ist, **dadurch gekennzeichnet,** daß auf dem Träger (1) die Al₂O₃-Schicht (7) bei maximal 700 °C, vorzugsweise 550 °C, vollständig kristallin aufgebracht ist und aus der α-Al₂O₃-Phase und gegebenenfalls der γ-Al₂O₃-Phase mit einer (440)-Textur besteht, eine Druckeigenspannung von mindestens 1 GPa und eine Härte von mindestens 20 GPa hat, und daß in der Al₂O₃-Schicht (7) mit Ausnahme von Argon keine nennenswerten Verunreinigungen eingelagert sind.

2. Vakuumbeschichteter Verbundkörper nach Anspruch 1, **dadurch gekennzeichnet,** daß mindestens eine zwischen der Al₂O₃-Schicht (7) und dem Träger (1) aufgebrachte Schicht (2) aus einem Metall und/oder einer Metallverbindung aus der Gruppe Ti, Zr, Cr, Al, Nb, Hf, W besteht.

3. Vakuumbeschichteter Verbundkörper nach den Ansprüchen 1 und 2, **dadurch gekennzeichnet,** daß die Metallverbindungen Oxide, Nitride, Oxinitride, Karbide oder Carbonitride sind.

4. Vakuumbeschichteter Verbundkörper nach den Ansprüchen 1 bis 3, **dadurch gekennzeichnet,** daß die Al₂O₃-Schicht (7) eine Dicke von 1 bis 20 µm, vorzugsweise 3 µm hat.

5. Vakuumbeschichteter Verbundkörper nach den Ansprüchen 1 bis 4, **dadurch gekennzeichnet,** daß auf dem Träger (1) neben der äußeren Al₂O₃-Schicht (7) weitere Schichten aus Al₂O₃ im Wechsel mit Schichten aus Metallen der Gruppe Ti, Zr, Cr, Al, Nb, Hf, W und/oder Verbindungen dieser Metalle aufgebracht sind.

6. Verfahren zur Herstellung eines vakuumbeschichteten Verbundkörpers, indem auf dem Träger aus Metall oder einer Metallegierung mindestens eine Schicht im Vakuum aufgebracht wird und dabei die äußerste Schicht aus Al₂O₃ durch reaktives Magnetron-Zerstäuben aufgebracht wird, nach Anspruch 1, **dadurch gekennzeichnet,** daß die Al₂O₃-Schicht durch gepulste Magnetronzerstäubung bei Zuführung von sauerstoffhaltigem Gas aufgebracht wird, daß die Pulsfrequenz auf 20 bis 100 kHz, vorzugsweise 50 kHz, eingestellt wird, daß mit einer Zerstäubungsrate von mindestens 1 nm/s, bezogen auf einen stationär angeordneten Träger, abgeschieden wird und daß ein pulsförmiger im Wechsel von positiven und negativen Ladungsträgern getragener Strom mit einer mittleren Stromdichte von mindestens 1 mA/cm² und einer Pulswechselfrequenz von mindestens 5 kHz auf den Träger auftrifft.

7. Verfahren nach Anspruch 6, **dadurch gekennzeichnet,** daß die Al₂O₃-Schicht durch Zerstäuben zweier gemeinsam wirkender Al-Targets, die wechselweise als Katode und Anode einer Magnetron-Zerstäubungseinrichtung geschaltet werden, aufgebracht wird.

8. Verfahren nach Anspruch 6, **dadurch gekennzeichnet,** daß die Al₂O₃-Schicht durch Zerstäuben eines Al-Targets einer Magnetron-Zerstäubungseinrichtung aufgebracht wird.

9. Verfahren nach mindestens einem der Ansprüche 6 bis 8, **dadurch gekennzeichnet,** daß besagte Zwischenschichten ebenfalls durch Vakuumbeschichtung, insbesondere durch Magnetron-Zerstäubung aufgebracht werden.

## Claims

1. A vacuum coated composite body consisting of a substrate of metal or a metal alloy, on which is applied at least one layer as the outermost layer of Al₂O₃ in a vacuum coating process, characterized in that the Al₂O₃ layer (7) is applied on the substrate (1) completely crystalline at a maximum of 700°C, preferably 550 °C, and consists of the α-Al₂O₃ phase and optionally the γ-Al₂O₃ phase with a (440) texture, a compressive internal stress of at least 1 GPA and a hardness of at least 20 GPa, and in that no appreciable impurities are incorporated in the Al₂O₃ layer (7) with the exception of argon.

2. A vacuum coated composite body according to claim 1, characterized in that at least one layer (2) applied between the Al₂O₃ layer (7) and the substrate (1) consists of a metal and/or a metal compound from the group Ti, Zr, Cr, Al, Nb, Hf, W.

3. A vacuum coated composite body according to claims 1 and 2, characterized in that the metal compounds are oxides, nitrides, oxy-nitrides, carbides or carbo-nitrides.

4. A vacuum coated composite body according to claims 1 to 3, characterized in that the Al₂O₃ layer (7) has a thickness of 1 to 20 µm, preferably 3 µm.

5. A vacuum coated composite body according to claims 1 to 4, characterized in that further layers of Al₂O₃ are applied to the substrate (1), as well as the outer Al₂O₃ layer (7), alternating with layers of metals from the group Ti, Zr, Cr, Al, Nb, Hf, W and/or compounds of these metals.

6. A method of making a vacuum coated composite body, in which at least one layer is applied in a vacuum to the substrate of metal or a metal alloy and the outermost layer of Al₂O₃ is applied by reactive magnetron sputtering, according to claim 1, characterized in that the Al₂O₃ layer is applied by pulsed magnetron sputtering with a supply of oxygen-containing gas, in that the pulse frequency is adjusted from 20 to 100 kHz, preferably 50 kHz, in that deposition is effected with a sputtering rate of at least 1 nm/s, referred to a stationary substrate, and in that a pulsed current alternating between positive and negative charge carriers impinges on the substrate with a mean current density of at least 1 mA/cm² and a pulse alternation frequency of at least 5 kHz.

7. A method according to claim 6, charactenzed in that the Al₂O₃ layer is applied by atomising two Al targets acting in common, which are switched alternately as cathode and anode of a magnetron sputtering device.

8. A method according to claim 6, charactenzed in that the Al₂O₃ layer is applied by atomising an Al target of a magnetron sputtering device.

9. A method according to at least one of claims 6 to 8, characterized in that the said intermediate layers are also applied by vacuum coating, especially by magnetron sputtering.

## Revendications

1. Corps composite revêtu sous vide, se composant d'un support en métal ou en alliage métallique sur lequel est appliquée au moins une couche, en tant que couche extérieure, en Al₂O₃ dans un processus d'enduction sous vide,
caractérisé en ce que
sur le support (1) est appliquée de manière complètement cristalline la couche (7) d'Al₂O₃ à une température maximale de 700°C, de préférence de 550°C, et elle se compose de la phase d'Al₂O₃-α et éventuellement de la phase d'Al₂O₃-γ avec une texture (440) et elle a une tension propre de compression d'au moins 1 Gpa et une dureté d'au moins 20 Gpa et en ce que dans la couche 7 d'Al₂O₃ ne sont pas insérées d'impuretés notables à l'exception de l'argon.

2. Corps composite recouvert sous vide selon la revendication 1,
caractérisé en ce qu'
au moins une couche (2) appliquée entre la couche (7) d'Al₂O₃ et le support (1) est composée d'un métal et/ou d'un composé métallique du groupe Ti, Zr, Cr, Al, Nb, Hf, W.

3. Corps composite recouvert sous vide selon les revendications 1 et 2,
caractérisé en ce que
les composés métalliques sont des oxydes, des nitrures, des oxynitrures, des carbures ou des carbonitrures.

4. Corps composite recouvert sous vide selon les revendications 1 à 3,
caractérisé en ce que
la couche (7) d'Al₂O₃ a une épaisseur de 1 à 20 µm, de préférence 3 µm.

5. Corps composite recouvert sous vide selon les revendications 1 à 4,
caractérisé en ce que
sur le support (1) outre la couche extérieure d'Al₂O₃ (7) sont appliquées d'autres couches d'Al₂O₃ en alternance avec des couches de métaux du groupe Ti, Zr, Cr, Al, Nb, Hf, W et/ou de composés de ces métaux.

6. Procédé de fabrication d'un corps composite enduit sous vide, sur lequel on applique sous vide sur le support en métal ou en un alliage métallique au moins une couche et à ce propos la couche la plus extérieure en Al₂O₃ par atomisation réactive au magnétron, selon la revendication 1,
caractérisé en ce que
la couche d'Al₂O₃ est appliquée par atomisation au magnétron pulsée lors de l'amenée de gaz contenant de l'oxygène, en ce que la fréquence de pulsation est ajustée à 20 jusqu'à 100 kHz, de préférence à 50 kHz, en ce qu'elle est déposée à une vitesse d'atomisation d'au moins 1 nm/s par rapport à un support disposé fixe et en ce qu'elle rencontre sur le support un courant sous forme d'impulsions, porté en alternance par des porteurs de charge positifs et négatifs ayant une densité moyenne de courant de 1mA/cm² et une fréquence alternative de pulsation d'au moins 5 kHz sur le support.

7. Procédé selon la revendication 5,
caractérisé en ce que
la couche d'Al₂O₃ est appliquée par atomisation de deux cibles d'Al agissant en commun, qui sont branchées tour à tour comme cathode et anode d'un dispositif d'atomisation par magnétron.

8. Procédé selon la revendication 5,
caractérisé en ce que
la couche d'Al₂O₃ est appliquée par atomisation d'une cible d'Al d'un dispositif d'atomisation par magnétron.

9. Procédé selon au moins une des revendications 5 à 7,
caractérisé en ce que
les couches intermédiaires mentionnées ci-dessus sont appliquées également par revêtement sous vide, en particulier par atomisation par magnétron.
